Europäisches Patentamt

European Patent Office

Office européen des brevets

(19)

(11) **EP 1 282 254 A1**

(12) **DEMANDE DE BREVET EUROPEEN**

(43) Date de publication:
**05.02.2003 Bulletin 2003/06**

(51) Int Cl.$^7$: **H04L 1/00**, H03M 13/29

(21) Numéro de dépôt: 02077986.4

(22) Date de dépôt: **22.07.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **31.07.2001 FR 0110249**

(71) Demandeur: **Koninklijke Philips Electronics N.V.
5621 BA Eindhoven (NL)**

(72) Inventeurs:
• **Chouly, Antoine, Société Civile S.P.I.D.
75008 Paris (FR)**
• **Pothier, Olivier, Société Civile S.P.I.D.
75008 Paris (FR)**

(74) Mandataire: **Chaffraix, Jean
Société Civile S.P.I.D.
156, Boulevard Haussmann
75008 Paris (FR)**

(54) **Codage et décodage de canal pour modulation à grand nombre d'etats**

(57)    L'invention concerne une méthode de codage/décodage associant la modulation/démodulation au codage/décodage de canal pour améliorer les performances au niveau du décodage dans le cas d'une modulation a grand nombre d'états. Le procédé de décodage itératif implique une paire de décodeurs SISO recevant en entrée des informations de vraisemblance sur des symboles pour fournir en sortie des informations de probabilité a posteriori sur les symboles d'information émis.

Application : télécommunications numériques.

FIG.3

**Description**

L'invention concerne un émetteur comportant des moyens de codage de canal et de modulation pour transformer un flux de données binaires en signaux d'ondes représentés par des symboles à transmettre destinés à transporter lesdites données binaires dans un canal de transmission, lesdits signaux d'ondes étant sélectionnés dans une constellation à M états.

Elle concerne également un récepteur comportant des moyens de démodulation et de décodage de canal itératifs pour retrouver, à partir de signaux reçus, des symboles d'information sélectionnés dans un alphabet à M états.

L'invention concerne aussi un procédé de codage de canal et de modulation pour transformer un flux de données binaires en signaux d'ondes représentés par des symboles à transmettre destinés à transporter lesdites données binaires dans un canal de transmission, lesdits signaux d'ondes étant sélectionnés dans une constellation à M états

Elle concerne également un procédé de démodulation et décodage de canal pour retrouver des symboles d'information émis sélectionnés dans un alphabet à M états à partir de signaux reçus.

L'invention concerne enfin des programmes d'ordinateur pour mettre en oeuvre les procédés ci-dessus et un signal pour transporter lesdits programmes d'ordinateur.

L'invention a de nombreuses applications notamment dans les transmissions vidéo numériques par satellite, les systèmes de réseaux sans fil et les systèmes de télécommunications radio mobiles.

L'article de S. Le Goff, A. Glavieux et C. Berrou intitulé "Turbo-codes and high spectral efficiency modulation" publié lors de l'International Conference on Communication, 1994, pp. 645-649, décrit une méthode de codage / décodage de canal utilisant, appliqué à des modulations à grand nombre d'états, le principe du turbo-codage tel que décrit par C. Berrou, A. Glavieux et P. Thitimajshima dans l'article intitulé "Near Shannon limit error-correcting coding and decoding: Turbo-codes" publié dans l'International Conference on Communication, 1993, pp. 1064-1070. Selon cette méthode, dite de type pragmatique, le décodage de canal comporte une étape préliminaire de calcul de vraisemblances pour chaque bit de chaque symbole reçu, de sorte que le décodage de canal s'effectue ensuite comme dans le cas binaire, c'est-à-dire que les décodeurs, du type recevant et délivrant des indications de probabilités, appelés aussi de type SISO (de l'anglais Soft Input Soft Output), reçoivent en entrée des probabilités sur des données binaires constitutives des symboles reçus. Au niveau du décodage, cette méthode n'est pas optimale car les données binaires en entrée des décodeurs SISO appartenant à un même symbole à transmettre ne sont pas indépendantes, ce qui réduit notablement les performances du décodage.

Un objet de l'invention est de fournir des moyens de codage et de décodage de canal adaptés à des modulations à grand nombre d'états permettant d'améliorer les performances au niveau du décodage de canal.

Pour cela, il est prévu un émetteur du genre mentionné dans le paragraphe introductif, remarquable en ce que lesdits moyens de codage de canal et de modulation comprennent :

- des moyens de conversion en amont pour convertir ledit flux de données binaires en un flux de symboles d'information, dit flux d'entrée, de sorte que le nombre de symboles d'information possibles est égal au nombre M de signaux de ladite constellation,
- des moyens d'entrelacement pour entrelacer lesdits symboles d'information du flux d'entrée et générer un flux de symboles d'information entrelacés, dit flux d'entrée entrelacé,
- au moins un premier et un deuxième codeurs fonctionnant en parallèle, pour recevoir ledit flux d'entrée et ledit flux d'entrée entrelacé, respectivement, pour délivrer des flux de sortie contenant :

    i. des indications relatives auxdits symboles d'information et des premières informations de redondance introduites par le premier codeur d'une part et
    ii. des deuxièmes informations de redondance introduites par le deuxième codeur d'autre part,

- des moyens de sélection pour déterminer, à partir desdits flux de sortie, lesdits signaux d'ondes à transmettre.

En émission, le flux de données binaires à transmettre est transformé en symboles sélectionnés parmi un alphabet de même taille que la taille de la constellation utilisée pour la modulation. Le codeur de canal reçoit ainsi en entrée des symboles d'information au lieu de données binaires. De façon avantageuse, la détermination des symboles à transmettre est immédiate, partant de symboles d'entrée sélectionnés parmi un alphabet ayant la même cardinalité que la constellation utilisée pour la modulation.

Il est également prévu un récepteur du genre mentionné dans le paragraphe introductif, remarquable en ce que lesdits moyens de démodulation et de décodage de canal itératifs comportent :

- des moyens de réception pour recevoir lesdits signaux et les convertir en symboles de données, dit symboles reçus,

- des moyens de calcul de vraisemblance pour délivrer des vecteurs de vraisemblance comprenant, pour chaque symbole reçu, des indications de vraisemblance relatives auxdits symboles d'information et des indications de vraisemblance relatives à des indications de redondance fournies par un codeur à l'émission à partir desdits symboles d'informations,
- une suite de décodeurs, dits décodeurs SISO, fonctionnant par paires successives et recevant en entrée, au moins :

    i. lesdits vecteurs de vraisemblance et

    ii. des indications indépendantes des symboles reçus relatives aux symboles d'information, dites informations *a priori,*

  pour délivrer en sortie, au moins :

    iii. des résultats relatifs aux symboles d'information, dites informations extrinsèques, et

    iv. des indications de probabilité *a posteriori* sur les symboles d'information, dites informations *a posteriori,*

- au moins un bloc de décision pour sélectionner lesdits symboles d'information à partir desdites informations *a posteriori*.

De cette façon, les symboles en entrée des décodeurs SISO sont indépendants entre eux, ce qui améliore l'efficacité du décodage.

La description suivante, donnée à titre d'exemple non limitatif pour illustrer comment l'invention peut être réalisée, est faite en regard des dessins ci-annexés, dans lesquels :

- la figure 1 est un schéma bloc fonctionnel pour illustrer un exemple de système de transmission classique,
- la figure 2 est un schéma bloc fonctionnel pour illustrer un exemple d'émetteur selon l'invention,
- la figure 3 est un schéma bloc fonctionnel pour illustrer un exemple de récepteur selon l'invention,
- la figure 4 est un schéma bloc fonctionnel pour illustrer un mode de réalisation d'un décodeur SISO selon l'invention.

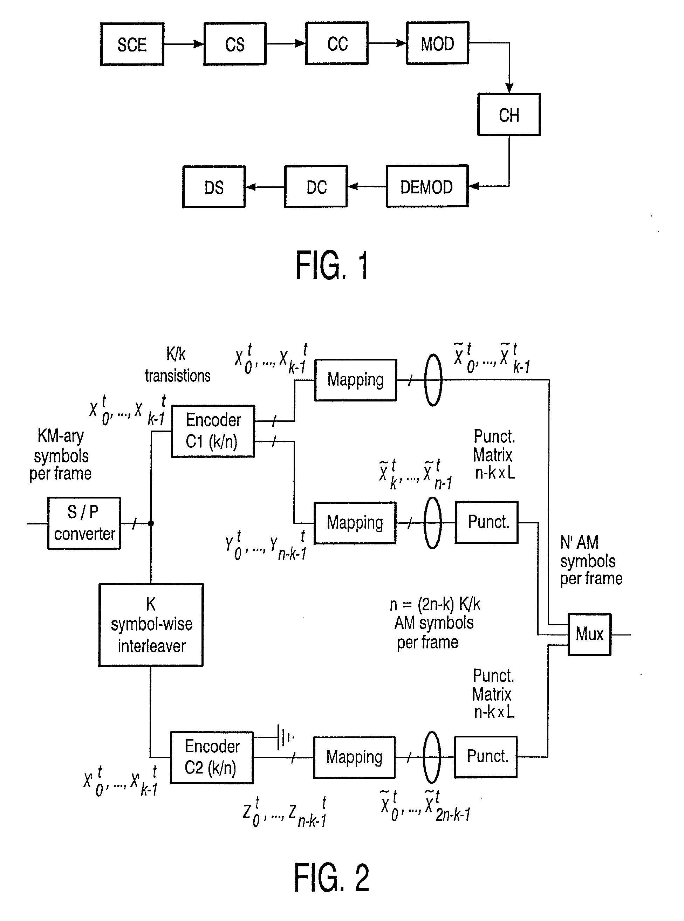

La figure 1 est un schéma bloc fonctionnel représentant un exemple de système de transmission classique. Il comprend un émetteur réalisant une chaîne d'émission, un récepteur réalisant une chaîne de réception et un canal de transmission. L'émetteur et le récepteur communiquent via le canal de transmission, la chaîne d'émission comprend :

- une source SCE pour fournir un signal de source qui peut être analogique, comme un signal audio ou vidéo ou numérique, comme la sortie d'un appareil fax, mais qui devra de toutes façons, dans un systèmes de transmissions numériques, être converti en une séquence de données binaires,
- un codeur de source CS pour réduire la quantité de données binaires à transmettre sur le canal et délivrer une séquence d'informations binaires à destination d'un codeur de canal,
- un codeur de canal CC pour introduire de la redondance dans la séquence d'informations binaires à transmettre sur le canal en vue de la protéger contre des erreurs de transmission, le codeur de canal est caractérisé par son rendement, noté k/n avec k<n, k représentant le nombre de données binaires parallèles en entrée du coeur et n représentant le nombre de données binaires parallèles en sortie du codeur, formant une séquence à n-bits, également appelée mot de code,
- un modulateur MOD pour réaliser l'interface entre le canal de transmission et l'émetteur, en transformant la séquence binaire ou mot de code fournie par le codeur de canal en un unique signal d'onde électrique à transmettre sur le canal.

Dans un exemple de réalisation avantageux de l'invention, le modulateur est prévu pour transmettre m bits d'information en même temps, à l'aide d'une constellation, dite M-aire, à M états distincts avec $M = 2^m$.

Le canal de transmission CH est un médium physique utilisé pour transmettre les signaux d'ondes de l'émetteur au récepteur. Il peut être matérialisé de plusieurs manières : par l'air, dans le cas de communications sans fil, hertziennes ou satellite, par un câble dans le cas d'un réseau câblé, par des fibres optiques, etc.

La chaîne de réception comprend :

- un démodulateur numérique DEMOD pour traiter les signaux d'ondes reçus et les convertir en séquences de chiffres représentant des estimations du symbole de la constellation M-aire transmis,

- un décodeur de canal DC pour reconstruire la séquence d'informations originale à partir du symbole récupéré, connaissant la méthode de codage utilisée par le codeur de canal à l'émission, et enfin
- un décodeur de source DS pour reconstruire le signal binaire original, connaissant la méthode de codage utilisée par le codeur de source à l'émission.

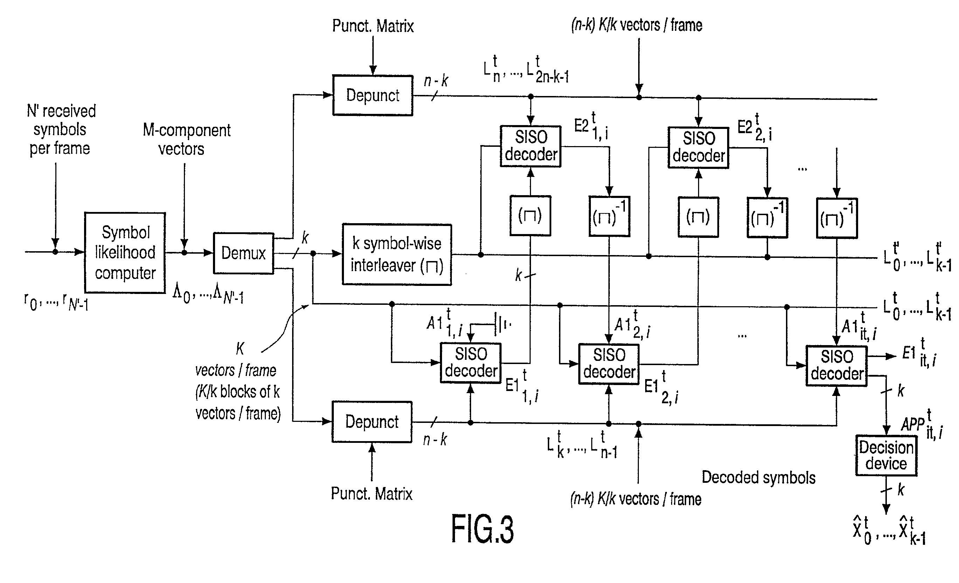

La présente invention concerne plus particulièrement les parties codage/décodage de canal et modulation/démodulation. La chaîne de transmission classique est conservée, sauf qu'à l'émission, le codage de canal et la modulation sont effectués ensemble à l'aide de moyens de codage de canal et de modulation et qu'en réception, le décodage de canal et la démodulation sont également effectués ensemble par des moyens de démodulation et de décodage de canal, pour optimiser les différents traitements successifs. Les figures 2 et 3 illustrent donc un émetteur et un récepteur, respectivement, selon l'invention, dont seules les parties qui diffèrent de la chaîne classique ont été représentées.

Dans la description suivante, un seul exemple d'application de l'invention est décrit pour des raisons de concision. Il concerne un type de modulation d'amplitude particulier ayant un nombre d'états distincts égal à M, dite modulation d'amplitude M-aire, avec M entier supérieur à 2, où M est généralement une puissance de 2. Des exemples de ce type de modulations d'amplitude sont les modulations M-AM et $M^2$-QAM. Mais l'invention s'applique également à d'autres modulations, notamment du type à sauts de phase appelées modulations PSK (de l'anglais Phase Shift Keying).

La figure 2 représente un exemple de réalisation d'un émetteur selon l'invention pour transformer un flux de données binaires en signaux d'ondes destinés à transporter lesdites données binaires dans un canal de transmission. Les signaux d'ondes sont représentés par des symboles à transmettre sélectionnés dans une constellation à M états. Seuls les moyens de codage de canal et de modulation sont représentés sur la figure 2 ; les autres parties de la chaîne d'émission sont identiques à la chaîne classique illustrée à la figure 1.

Les moyens de codage de canal et de modulation selon l'invention comprennent :

- des moyens de conversion en amont pour convertir ledit flux de données binaires en un flux de symboles d'information, dit flux d'entrée, de sorte que le nombre de symboles d'information possibles est égal au nombre M d'états de ladite constellation,
- des moyens d'entrelacement pour entrelacer lesdits symboles d'information du flux d'entrée et générer un flux de symboles d'information entrelacés, dit flux d'entrée entrelacé,
- un premier et un deuxième codeurs fonctionnant en parallèle et recevant le flux d'entrée et le flux d'entrée entrelacé, respectivement, pour délivrer des flux de sortie contenant :

    iii. des indications relatives aux symboles d'information et des premières informations de redondance introduites par le premier codeur d'une part et
    iv. des deuxièmes informations de redondance introduites par le deuxième codeur d'autre part,

- des moyens de sélection pour déterminer les signaux d'ondes à transmettre à partir des flux de sortie,
- optionnellement, des moyens de poinçonnage pour adapter le rendement du codeur de canal au débit souhaité en sortie du codeur, consistant à supprimer des données dans les flux de sortie,
- un multiplexeur de sortie pour multiplexer les différents flux de sortie dans un unique flux de sortie à émettre sur le canal.

Selon un mode de réalisation préféré de l'invention, les moyens de conversion en amont comprennent une table de correspondance pour convertir une suite de m bits dans le flux de données binaires, avec $m=\log_2(M)$ en un symbole d'information sélectionné parmi les M symboles d'information possibles. Dans le cas d'une modulation d'amplitude à 4 états ou modulation 4-AM, avec M=4 et m=2, les symboles prennent des valeurs dans l'ensemble ou constellation {-3, -1, 1, 3}. Un exemple de table de correspondance est représenté par la table 1 qui consiste en un codage de Gray de la constellation. D'autres types de codage peuvent bien entendu être utilisés.

Table 1

| -3 | -1 | 1 | 3 |
|----|----|----|----|
| 00 | 01 | 10 | 11 |

Les premier et deuxième codeurs sont des codeurs concaténés fonctionnant en parallèle. Ce sont des codeurs systématiques, c'est-à-dire du type comportant une sortie reproduisant les données d'entrée,. Deux codeurs sont représentés sur la figure 1 mais le nombre de codeurs fonctionnant en parallèle n'est pas limité. Chaque codeur est un codeur en treillis systématique pour une modulation M-aire. Il reçoit en entrée k symboles d'information en parallèle, sélectionnés parmi une constellation à M états, notés $X^t=(X_0^t, ..., X_{k-1}^t)$, et délivre sur une première sortie les k symboles d'entrée $X^t=(X_0^t, ..., X_{k-1}^t)$ et sur une deuxième sortie, les n-k symboles de redondance introduites par le codeur, notées $Y^t=(Y_0^t, ..., Y_{n-k-1}^t)$. Selon l'exemple de réalisation représenté sur la figure 1, les codeurs ont un rendement de codage, noté k/n et k'/n' respectivement, où k et k' sont des entiers représentant un nombre de symboles d'informations traités en parallèle en entrée du codeur, de sorte que k= k' et où n et n' sont des entiers représentant des nombres de symboles codés délivrés en parallèle en sortie du codeur, respectivement. Le codeur peut consister en une machine à état classique recevant en entrée k symboles d'information en parallèle appartenant à un alphabet M-aire [0, ..., M-1]. A partir de cette entrée, et de l'état courant de la machine d'états, une table de correspondance sélectionne l'état suivant et les n-k symboles de redondance M-aires. Le choix du codeur n'est pas limité aux codeurs ayant une représentation en diagramme block sous forme de registre à décalage spécifique. De préférence, les codeurs seront du type ayant la propriété de circularité du treillis, tail-biting en anglais. Le choix du codeur dépend également de la modulation et des paramètres de sélection des signaux d'ondes à transmettre sur le canal.

Le figure 2 représente deux codeurs systématiques concaténés. Le flux d'entrée binaire est formaté en trames de K symboles M-aires avec $M = 2^m$, c'est-à-dire que chaque symbole est représenté dans la trame par m bits. Une permutation sur les K symboles de la trame est ensuite réalisée par les moyens d'entrelacement. La trame de symboles d'information originale est fournie en entrée du premier codeur tandis que la trame entrelacée est fournie en entrée du deuxième codeur. Pour chaque codeur, le procédé de codage comporte K/k étapes par trame de symboles d'information en entrée des moyens de codage et de modulation. A chaque étape, n-k symboles de redondance sont générés par chaque codeur, ce qui fait 2n-k symboles générés en tout à l'issue d'une étape de codage :

- k symboles d'information identiques aux symboles d'entrée,
- n-k symboles de redondance introduits par le premier codeur,
- n-k symboles de redondance introduits par le deuxième codeur.

Ces symboles sont alors remplacés par des signaux d'ondes à transmettre sur le canal, selon la modulation utilisée. Pour augmenter les performances du codeur, en particulier son efficacité spectrale, des moyens de poinçonnage peuvent être utilisés en sortie de chaque codeur, pour supprimer des données dans les flux de symboles de redondance. Finalement, un multiplexage est réalisé pour multiplexer les 3 flux de symboles en sortie des moyens de codage et de modulation.

Le fonctionnement du décodage est illustré à la figure 3. Elle représente un exemple de récepteur selon l'invention, comportant des moyens de démodulation et de décodage de canal itératifs pour retrouver, à partir de symboles reçus, des symboles d'information sélectionnés dans une constellation à M états. Les moyens de démodulation et de décodage de canal itératifs comportent :

- des moyens de calcul de vraisemblance pour délivrer des vecteurs de vraisemblance à M composantes, notés $\Lambda_0, ...,\Lambda_{N'-1}$, où N' représente le nombre de symboles reçus par trame, comprenant, pour chaque symbole reçu, notés $r_0, ..., r_{N'-1}$, des indications de vraisemblance relatives à chaque symbole d'information, et des indications de vraisemblance relatives aux symboles de redondance fournies par les différents codeurs à l'émission, à partir des symboles d'informations ou symboles d'entrée des codeurs,
- un démultiplexeur pour transformer le flux série de vecteurs de vraisemblance en trois flux parallèles :

    i. un premier flux, noté $L_0^t, ...L_{k-1}^t$, contenant les k vecteurs de vraisemblance comportant les indications de vraisemblance relatives aux k symboles d'information du flux d'entrée des moyens de codage à l'émission,

    ii. un deuxième flux, noté $L_k^t, ...L_{n-1}^t$, contenant les n-k vecteurs de vraisemblance comportant les indications de vraisemblance relatives aux n-k symboles de redondance générés par le premier codeur à l'émission,

    iii. un troisième flux, noté $L_n^t, ...L_{2n-k-1}^t$, contenant les vecteurs de vraisemblance comportant les indications de vraisemblance relatives aux n-k symboles de redondance générés par le deuxième codeur à l'émission

- une suite de décodeurs, dits décodeurs SISO, fonctionnant par paires successives et recevant en entrée, au moins:

    i. une partie des vecteurs de vraisemblance et

    ii. des indications indépendantes des symboles reçus relatives aux symboles d'information, appelées informations *a priori,* notées $A1_{iter,i}^t$ et $A2_{iter,i}^t$, respectivement, iter étant l'indice de l'itération et i étant compris entre 0 et k-1,

pour délivrer en sortie, au moins :

iii. des résultats relatifs aux symboles d'information, dites informations extrinsèques, notées $E1_{iter,i}^{t}$ et $E2_{iter,i}^{t}$, respectivement, et

iv. des indications de probabilité *a posteriori* sur les symboles d'information, dites informations *a posteriori,* notées $APP1_{iter,i}^{t}$ et $APP2_{iter,i}^{t}$, respectivement

- au moins un bloc de décision, situé en sortie d'au moins un décodeur SISO, pour sélectionner les symboles d'information recherchés, à partir des informations *a posteriori* délivrées par le décodeur en question.

Selon un mode de réalisation préféré de l'invention, une paire de décodeurs SISO utilisée lors de l'itération numéro i, notée $(SISO_{1,i}, SISO_{2,i})$, fonctionne de la façon suivante :

- un premier décodeur SISO, noté $SISO_{1,i}$, reçoit en entrée :

i. des vecteurs de probabilité *a priori,* notées $A1_{iter,0}$,... $A1_{iter,k-1}$,
ii. des vecteurs de vraisemblance contenant des indications de vraisemblance sur des symboles reçus correspondant aux symboles d'information, notées $L_0^{t}$, ...$L_{k-1}^{t}$,
iii. des vecteurs de vraisemblance sur des symboles reçus correspondant à des premières indications de redondance délivrées par un premier codeur à l'émission, à partir desdits symboles d'informations, notées $L_k^{t}$, ...$L_{n-1}^{t}$,

et délivre en sortie :

iv. des premières informations extrinsèques, notées $E1_{iter,0}^{t}$, ... $E1_{iter,k-1}^{t}$ et
v. des premières informations *a posteriori,* notées $APP1_{iter,0}^{t}$, ... $APP1_{iter,k-1}^{t}$,

- des moyens d'entrelacement pour entrelacer les premières informations extrinsèques (iv) d'une part, et les indications de vraisemblance sur les symboles reçus correspondant aux symboles d'information (ii) d'autre part, pour fournir :

vi. des premières informations extrinsèques entrelacées d'une part et
vii. des indications de vraisemblance sur les symboles entrelacées d'autre part,

- un deuxième décodeur SISO, noté $SISO_{1,i}$, reçoit en entrée :

viii. les premières informations extrinsèques entrelacées (vi) en tant qu'informations *a priori*,
ix. lesdites indications de vraisemblance entrelacées (vii),
x. des indications de vraisemblance sur des symboles reçus correspondant à des deuxièmes indications de redondance délivrées par un deuxième codeur à l'émission, notées $L_n^{t}$, ...$L_{2n-k-1}^{t}$,

pour délivrer en sortie :

xi. des deuxièmes informations extrinsèques, notées $E2_{iter,0}^{t}$, ... $E2_{iter,k-1}^{t}$ et
xii. des deuxièmes informations a *posteriori*, notées $APP1_{iter,0}^{t}$, ... $APP1_{iter,k-1}^{t}$,

- des moyens d'entrelacement inverse pour désentrelacer les deuxièmes informations extrinsèques (xi) d'une part et les deuxièmes informations a *posteriori* (xii) d'autre part et pour fournir les deuxièmes informations extrinsèques (xi) en tant qu'informations *a priori* en entrée du premier décodeur SISO de la paire suivante, noté $SISO_{1,i+1}$.

Selon ce mode de réalisation, chaque itération du procédé de décodage consiste en un traitement par une paire de décodeurs SISO. Le premier décodeur $SISO_{1,1}$ reçoit des information *a priori* prédéfinies $A1_{1,1}^{t}$ à $A1_{1,k}^{t}$ ainsi que les indications de vraisemblance $L_0^{t}$, ...$L_{k-1}^{t}$ correspondant aux symboles d'information, d'une part, et celles correspondant aux informations de redondance introduites par le premier codeur de la figure 1, $L_k^{t}$, ...$L_{n-1}^{t}$, d'autre part. Il délivre des premières informations extrinsèques $E1_{1,1}^{t}$ qui sont entrelacées pour être fournies en entrée du deuxième décodeur de la paire $SISO_{2,1}$ en tant qu'information *a priori.* Le deuxième décodeur utilise ces informations avec la version entrelacées des indications de vraisemblance $L'_0^{t}$, ...$L'_{k-1}^{t}$, correspondant aux symboles d'information, et les indications de vraisemblance $L_n^{t}$, ...$L_{2n-k-1}^{t}$ correspondant aux informations de redondance introduites par le deuxième codeur de la figure 1, pour générer des deuxièmes informations extrinsèques $E2_{1,1}^{t}$ qui sont utilisées lors de l'itération suivante comme informations *a priori* par le premier décodeur $SISO_{1,2}$ de la paire suivante, après désentrelacement.

Des moyens de dépoinçonnage peuvent être utilisés pour remplacer les données supprimées lors du poinçonnage effectué durant le codage à l'émission. Ces moyens doivent être insérés en entrée des décodeurs SISO sur les flux d'entrée contenant les données $L_k^t$, ...$L_{n-1}^t$, et $L_n^t$, ...$L_{2n-k1}^t$. Si le rendement du codeur à l'émission a été adapté à l'aide d'un poinçonnage effectué sur les informations de redondance générées par les codeurs à l'émission, les indications de vraisemblances correspondant aux informations de redondance sont fixées à des valeurs prédéfinies équiprobables.

Une décision sur chaque symbole d'information est effectuée en sélectionnant, de préférence à l'issue de la dernière itération, mais de façon générale à tout moment durant le procédé de décodage, c'est-à-dire en sortie d'un décodeur d'indice it quelconque, le signal d'onde à transmettre sur le canal correspondant au symbole de la constellation M-aire qui a la probabilité *a posteriori* maximum d'après la valeur de la composante d'indice $\ell$ correspondant à ce symbole dans le vecteur de vraisemblance *a posteriori* à M composantes $APP_{it,\ell}^t$ en sortie du décodeur en question.

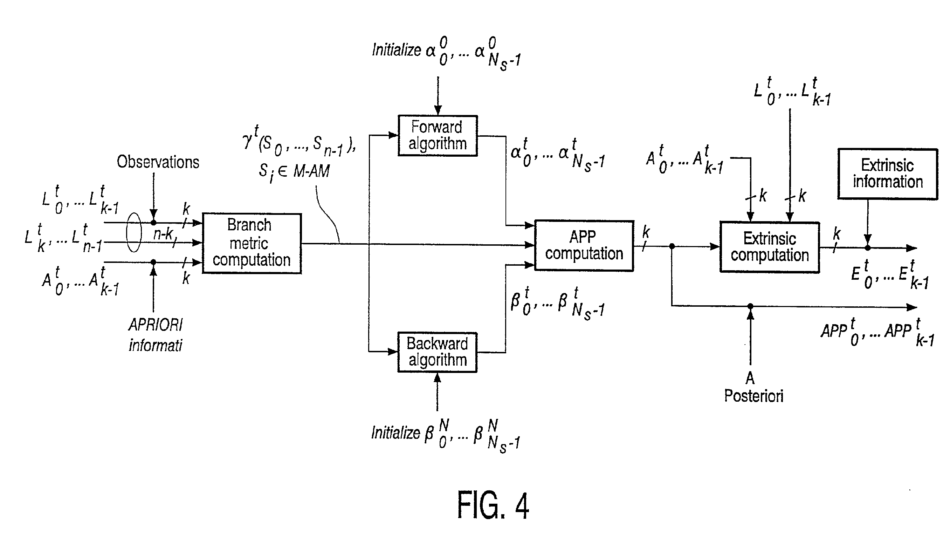

La figure 4 montre un exemple de réalisation d'un décodeur SISO utilisé dans l'exemple illustré à la figure 3. Il comprend

- des premiers moyens de calcul APP pour délivrer les indications de probabilité *a posteriori* $APP_0^t$, ...$APP_{k-1}^t$, à partir des vecteurs de vraisemblance $L_0^t$, ... $L_{k-1}^t$ et $L_k^t$, ... $L_{n-1}^t$ et des informations *a priori* $A_0^t$, ...$A_{k-1}^t$, et
- des deuxièmes moyens de calcul EXT pour délivrer les informations extrinsèques $Ext_0^t$, ...$Ext_{k-1}^t$, à partir des indications de probabilité a *posteriori*, $APP_0^t$, ...$APP_{k-1}^t$, des informations *a priori* $A_0^t$, ...$A_{k-1}^t$ et des vecteurs de vraisemblance comportant les indications de vraisemblance relatives aux symboles d'information $L_0^t$, ... $L_{k-1}^t$.

Les premiers moyens de calcul APP comprennent :

- un bloc de calcul de branche, noté BMC pour calculer des probabilités intermédiaires, notées $\gamma_t(m',m)$, à partir des observations sur les symboles reçus, $L_0^t$ à $L_{n-1}^t$ et des informations *a priori*, $A_0^t$ à $A_{k-1}^t$,
- un bloc de calcul, noté FA, pour effectuer une première récursion, dite récursion sur les alphas ou récursion avant ou Forward,
- un bloc de calcul, noté BA, pour effectuer une deuxième récursion, dite récursion sur les betas ou récursion arrière ou Backward,
- un bloc de calcul, noté AP, pour délivrer les informations *a posteriori* à partir des résultats fournis par les trois blocs précédents.

L'algorithme de décodage utilisé selon ce mode de réalisation peut être considéré comme une généralisation de l'algorithme dit aller-retour ou Forward-Backward en anglais tel que décrit dans l'article de L. R. Bahl, J. Cocke, F. Jelinek et J. Raviv : « Optimal decoding of linear codes for minimizing symbol error rate » publié dans IEEE Trans. On Information Theory, vol. 20, oo. 284-287, mars 1974, qui est habituellement appliqué à un code binaire. Il peut s'agir de différentes variantes d'implémentation, appelées MAP, log-MAP ou encore toute autre implémentation sous-optimale de ces algorithmes, comme décrites entre autre dans l'article de P. Robertson, P. Hoeher et E. Villebrun : « Optimal and Sub-optimal a Posteriori Algorithms Suitable for Turbo Decoding », publié dans European Trans. On Telecommunications, vol. 8, n° 2, pp. 119-125, mars-avril 1997.

Des modifications doivent être apportées par rapport à l'implantation classique de l'algorithme Forward-Backward qui s'applique au décodage d'un code convolutif binaire. Des modifications interviennent en amont :

- dans le calcul des vraisemblances des symboles reçus,
- dans le calcul des métriques de transitions entre états à partir des vraisemblances des symboles reçus et des probabilités *a priori* sur les symboles d'information.

L'algorithme Forward-Backward, ou l'une de ses variantes logarithmiques sous-optimales est alors appliqué classiquement.

D'autres différences notables par rapport à l'implantation classique de l'algorithme Forward-Backward interviennent en aval :

- dans le calcul des probabilités *a posteriori* des symboles d'information
- dans le calcul des informations extrinsèques des symboles d'information.

Ces différences sont explicitées ci-dessous, en utilisant les notations de l'article de L. R. Bahl, J. Cocke, F. Jelinek et J. Raviv. Le *calcul des vraisemblances des symboles reçus* est effectué par un démodulateur, appelé démodulateur souple (en anglais SoftDemodulator), qui réalise l'interface entre la sortie du canal et le début du turbo-décodage itératif. Le démodulateur souple est illustré à la figure 3 par les moyens de calcul de vraisemblance. Le démodulateur souple calcule les indications de vraisemblance sur les symboles. Pour le symbole reçu $Y_i^t$, cette indication de vraisemblance est un vecteur à $M$ composantes:

$$L_i^t = \left\{ R\left(Y_i^t / X_1\right),...,R\left(Y_i^t / X_M\right) \right\} \tag{1}$$

où $X_m$, $m \in \{1,...M\}$ correspond à chaque symbole de la constellation. Selon l'algorithme Forward-Backward ou l'une des ses variantes utilisée, le démodulateur calcule les vraisemblances différemment.

Dans le cas non-logarithmique, les vraisemblances sont définies par :

$$R\left(Y_i^t / X_m\right) = \Pr\left\{Y_i^t / X_m\right\} \tag{2}$$

Cette quantité ne dépend que des caractéristiques supposées connues du canal. Dans le cas d'un canal à bruit additif blanc Gaussien ou AWGN, elle s'exprime par :

$$R\left(Y_i^t / X_m\right) = \frac{1}{\left(\sqrt{2\pi\sigma^2}\right)^{dim}} \cdot \exp\left(-\frac{1}{2\sigma^2}\left\|Y_i^t - \tilde{X}_m\right\|^2\right) \tag{3}$$

où $\sigma^2$ représente la variance du bruit, $dim$ la dimension de la modulation, $\tilde{X}_m$ le signal émis correspondant au symbole $X_m$, et $\|\cdot\|$ la norme.

Pendant le calcul, une opération de normalisation est ajoutée

$$\hat{R}\left(Y_i^t / X_m\right) = \frac{R\left(Y_i^t / X_m\right)}{\sum_{m'} R\left(Y_i^t / X_{m'}\right)} \tag{4}$$

qui permet de s'affranchir du coefficient constant.

Dans le cas d'une version logarithmique de l'algorithme Forward-Backward (logMAP, MaxlogMAP, ou Corrective MaxlogMAP), les vraisemblances sont définies par :

$$R\left(Y_i^t / X_m\right) = \log\left(\Pr\left\{Y_i^t / X_m\right\}\right) \tag{5}$$

Pour un canal AWGN, en observant l'utilisation qui est faite des vraisemblances par l'algorithme (dans le calcul des métriques des branches), il est possible de réduire l'expression à :

$$R\left(Y_i^t / X_m\right) = \frac{1}{\sigma^2}\left(2.\left\langle Y_i^t, X_m\right\rangle - \left\|\tilde{X}_m\right\|^2\right) \tag{6}$$

où $\langle \cdot \rangle$ représente le produit scalaire. Dans le cas d'une modulation à énergie constante, les vraisemblances peuvent alors être calculées à l'aide de l'équation suivante :

$$R\left(Y_i^t / X_m\right) = \frac{2}{\sigma^2}\left\langle Y_i^t, \tilde{X}_m\right\rangle$$

Le *calcul des métriques de transitions entre états* $\gamma_t(m,m')$ à partir des vraisemblances des symboles reçus et des probabilités *a priori* sur les symboles d'information doit aussi être adapté au cas de symboles M-aire. La métrique de la transition à l'instant *t* entre les états *m* et *m'*s'écrit dans le cas non-logarithmique :

$$\gamma_t(m;m') = p_t(m/m')\prod_{i=1}^{n} R\left(Y_i^t / X_{i(m;m')}\right) \qquad (7)$$

où $X_{i(m;m')}$ correspond au *i*-ième symbole généré par le codeur lors d'une transition entre l'état *m* et l'état *m'*, et $Y_i^t$ son observation correspondante pour l'instant *t*. Il est à noter que chacun des termes du produit est la composante d'indice $i(m;m')$ du vecteur de vraisemblance $L_i^t$. La probabilité *a priori de* la transition de l'état $S_{t-1} = m'$ vers l'état $S_t = m$ s'exprime quant à elle par :

$$p_t(m/m') = \Pr\{S_t = m/S_{t-1} = m'\} = \prod_{i=1}^{k} A\left(X_i^t = X_{i(m;m')}\right) \qquad (8)$$

où

$$A\left(X_i^t = X_{i(m;m')}\right)$$

est la probabilité *a priori* que le symbole d'information $X_i^t$ soit égal au symbole correspondant de la transition entre *m* et *m'*. Il est à noter que chacun des termes du produit est la composante d'indice $i(m;m')$ du vecteur de probabilité *a priori* de $X_i^t : A_i^t$.

Dans le cas d'utilisation d'une version logarithmique de l'algorithme, tous les produits dans les équations (7) et (8) sont à remplacer par des sommes.

L'algorithme Forward-Backward, ou une de ces variantes, est alors appliqué de manière classique, avec les métriques de branche adaptées au cas où les données binaires sont remplacées par des symboles comme décrit par les équations (7) et (8). L'algorithme comporte trois étapes comme dans l'article de L. R. Bahl, J. Cocke, F . Jelinek et J. Raviv :

- une passe « aller » qui permet de calculer les

$$\alpha_t(m) = \Pr\{S_t = m; Y_1^t\}$$

- une passe « retour » qui permet de calculer les

$$\beta_t(m) = \Pr\{Y_{t+1}^T / S_t = m\}$$

- un calcul, à partir des $\alpha$, $\beta$ et $\gamma$ des $\sigma$ qui sont des valeurs proportionnelles aux probabilités *a posteriori* des transitions :

$$\sigma_t(m,m') = \Pr\{S_t = m; S_{t-1} = m'; \mathbf{Y}\} = \alpha_{t-1}(m').\gamma_t(m,m').\beta_t(m) \qquad (9)$$

où **Y** désigne toute l'observation en sortie du canal.

Le *calcul des probabilités a posteriori des symboles d'information* s'effectue à partir de ces quantités. Le vecteur de probabilité *a posteriori* du symbole d'information $X_i^t$ s'écrit :

$$APP_i^t = \left\{ \Pr\!\left(X_i^t = X_1/\mathbf{Y}\right), \cdots, \Pr\!\left(X_i^t = X_M/\mathbf{Y}\right) \right\} \qquad (10)$$

Chacun de ses termes s'exprime par :

$$\Pr\!\left\{X_i^t = X_j/\mathbf{Y}\right\} = \sum_{m',m\,/\,X_i^t = X_j} \sigma_t(m,m') = \sum_{m',m\,/\,X_i^t = X_j} \alpha_{t-1}(m').\gamma_t(m,m').\beta_t(m) \qquad (11)$$

où la somme est prise sur toutes les transitions des états $m$ vers les états $m'$ à l'instant $t$ qui font intervenir la valeur $X_j$ du symbole d'information à la position $i$.

Le *calcul des informations extrinsèques de chaque symbole d'information* peut se faire parallèlement au calcul des probabilités *a posteriori* sur le même symbole en ignorant dans les métriques de branches $\gamma_t(m,m')$, considérées à l'équation (11), les termes correspondant à la probabilité *a priori* et à la vraisemblance du symbole d'information considéré. Le vecteur d'information extrinsèque du symbole d'information $X_i^t$ s'écrit :

$$Ext_i^t = \left\{ Ext\!\left(X_i^t = X_1\right), \cdots, Ext\!\left(X_i^t = X_M\right) \right\} \qquad (12)$$

Chacun de ses termes se calcule avantageusement en introduisant le terme $\hat{\gamma}_t^i(m,m')$, qui correspond à la métrique de la branche ne contenant ni l'*a priori,* ni la vraisemblance de $X_i^t$ :

$$\hat{\gamma}_t^i(m;m') = \prod_{j=1,\,j\neq i}^{k} A\!\left(X_i^t = X_{j(m;m')}\right) \prod_{j=1,\,j\neq i}^{n} R\!\left(Y_j^t / X_{j(m;m')}\right) \qquad (13)$$

Grâce à cette quantité, les informations extrinsèques se calculent par :

$$Ext\!\left(X_i^t = X_j\right) = \sum_{m',m\,/\,X_i^t = X_j} \alpha_{t-1}(m').\hat{\gamma}_t^i(m,m').\beta_t(m) , \qquad (14)$$

Des opérations de normalisation similaires à l'équation (4) sont effectuées sur les vecteurs de probabilité *a posteriori* et sur les vecteurs d'informations extrinsèques :

$$\hat{APP}(X_i^t = X_u) = \frac{APP(X_i^t = X_u)}{\sum_v APP_t(X_i^t = X_v)} , \text{ et } \hat{Ext}(X_i^t = X_u) = \frac{Ext(X_i^t = X_u)}{\sum_v Ext_t(X_i^t = X_v)} \qquad (15)$$

Il est à noter que la généralisation du décodage à entrée et sortie souple d'un code convolutif binaire, à un code sur les symboles n'entraîne aucune modification de l'algorithme MAP, ou de ses variantes sous-optimales. Il ne s'agit que d'adapter les entrées et les sorties de l'algorithme à des données vectorielles correspondant à toutes les valeurs possibles des symboles. En particulier, les techniques classiques d'initialisation des quantités « alpha » et « beta » de l'algorithme sont valables, qu'il s'agisse d'un codage sans fermeture du treillis, avec forçage à zéro de l'état final, ou d'un codage circulaire (tail-biting en anglais).

Lors de la première itération de décodage, le premier décodeur SISO ne possède pas d'information sur les probabilités *a priori* des symboles d'informations. Les vecteurs $A_i^t$ sont donc initialisés de la manière suivante :

-   cas d'une implantation non-logarithmique :

$$\forall i, \forall t,\, A_i^t = \left\{ 1/M, \cdots, 1/M \right\} \qquad (16)$$

où $M$ est la cardinalité de l'alphabet des symboles

- cas d'une implantation logarithmique :

$$\forall i, \forall t,\ A_i^t = \left\{\log(1/M), \cdots, \log(1/M)\right\} \qquad (17)$$

On a ainsi décrit et illustré à l'aide d'exemples un émetteur, un récepteur, un procédé de codage et un procédé de décodage, un programme d'ordinateur et un signal adaptés à des modulations à grand nombre d'états pour améliorer les performances au niveau du décodage de canal. D'autres exemples de réalisation peuvent aisément être dérivés des exemples décrits sans sortir du cadre de l'invention. En particulier, l'invention n'est pas limitée aux modulations décrites dans les exemples.

**Revendications**

1. Emetteur comportant des moyens de codage de canal et de modulation pour transformer un flux de données binaires en signaux d'ondes représentés par des symboles à transmettre destinés à transporter lesdites données binaires dans un canal de transmission, lesdits signaux d'ondes étant sélectionnés dans une constellation à M états,
   **caractérisé en ce que** lesdits moyens de codage de canal et de modulation comprennent :

   - des moyens de conversion en amont pour convertir ledit flux de données binaires en un flux de symboles d'information, dit flux d'entrée, de sorte que le nombre de symboles d'information possibles est égal au nombre M de signaux de ladite constellation,

   - des moyens d'entrelacement pour entrelacer lesdits symboles d'information du flux d'entrée et générer un flux de symboles d'information entrelacés, dit flux d'entrée entrelacé,

   - au moins un premier et un deuxième codeurs fonctionnant en parallèle, pour recevoir ledit flux d'entrée et ledit flux d'entrée entrelacé, respectivement, pour délivrer des flux de sortie contenant :

     i. des indications relatives auxdits symboles d'information et des premières informations de redondance introduites par le premier codeur d'une part et

     ii. des deuxièmes informations de redondance introduites par le deuxième codeur d'autre part,

   - des moyens de sélection pour déterminer, à partir desdits flux de sortie, lesdits signaux d'ondes à transmettre.

2. Emetteur selon la revendication 1, dans lequel lesdits moyens de conversion comportent une table de correspondance pour convertir une suite de m bits dans le flux de données binaires, avec $m=\log_2(M)$ en un symbole d'information sélectionné parmi les M symboles d'information possibles.

3. Emetteur selon l'une des revendications 1 ou 2, dans lequel lesdits premier et deuxième codeurs ont un rendement de codage, noté k/n et k'/n' respectivement, k et k' étant des entiers représentant un nombre de symboles d'informations traités en parallèle en entrée du codeur, n et n' étant des entiers représentant des nombres de symboles codés délivrés en parallèle en sortie du codeur, respectivement, de sorte que k= k'.

4. Récepteur comportant des moyens de démodulation et de décodage de canal itératifs pour retrouver, à partir de signaux reçus, des symboles d'information sélectionnés dans un alphabet à M états,
   **caractérisé en ce que** lesdits moyens de démodulation et de décodage de canal itératifs comportent :

   - des moyens de réception pour recevoir lesdits signaux et les convertir en symboles de données, dit symboles reçus,

   - des moyens de calcul de vraisemblance pour délivrer des vecteurs de vraisemblance comprenant, pour chaque symbole reçu, des indications de vraisemblance relatives auxdits symboles d'information et des indications de vraisemblance relatives à des indications de redondance fournies par un codeur à l'émission à partir desdits symboles d'informations,

- une suite de décodeurs, dits décodeurs SISO, fonctionnant par paires successives et recevant en entrée, au moins:

    v. lesdits vecteurs de vraisemblance et

    vi. des indications indépendantes des symboles reçus relatives aux symboles d'information, dites informations *a priori*,

    pour délivrer en sortie, au moins :

    vii. des résultats relatifs aux symboles d'information, dites informations extrinsèques, et

    viii. des indications de probabilité *a posteriori* sur les symboles d'information, dites informations *a posteriori*,

- au moins un bloc de décision pour sélectionner lesdits symboles d'information à partir desdites informations *a posteriori.*

**5.** Récepteur selon la revendication 4, dans lequel les décodeurs SISO comprennent :

- des premiers moyens de calcul pour délivrer lesdites indications de vraisemblance *a posteriori* à partir desdits vecteurs de vraisemblance et desdites informations *a priori* et

- des deuxièmes moyens de calcul pour délivrer lesdites informations extrinsèques à partir desdites indications de vraisemblances *a posteriori*, desdites informations *a priori* et desdits vecteurs de vraisemblance comportant les indications de vraisemblance relatives auxdits symboles d'information.

**6.** Récepteur selon l'une des revendications 4 ou 5, dans lequel une paire de décodeurs SISO comporte :

- un premier décodeur SISO pour recevoir en entrée :

    i lesdites informations *a priori*,

    ii des indications de vraisemblance sur des symboles reçus correspondant auxdits symboles d'information,

    iii des indications de vraisemblance sur des symboles reçus correspondant à des premières indications de redondance délivrées par un premier codeur à l'émission, à partir desdits symboles d'informations,

    et pour délivrer en sortie des premières informations extrinsèques et des premières informations *a posteriori*:

- des moyens d'entrelacement pour entrelacer lesdites premières informations extrinsèques d'une part, et lesdites indications de vraisemblance sur les symboles reçus correspondant aux symboles d'information d'autre part, pour fournir des premières informations extrinsèques entrelacées d'une part et des indications de vraisemblance entrelacées d'autre part,

- un deuxième décodeur SISO pour recevoir en entrée :

    i. lesdites premières informations extrinsèques entrelacées en tant qu'informations *a priori,*

    ii. lesdites indications de vraisemblance entrelacées,

    iii. des indications de vraisemblance sur des symboles reçus correspondant à des deuxièmes indications de redondance délivrées par un deuxième codeur,

    pour délivrer en sortie des deuxièmes informations extrinsèques, d'une part et des deuxièmes informations *a posteriori,* d'autre part,

EP 1 282 254 A1

- des moyens d'entrelacement inverse pour desentrelacer les deuxièmes informations extrinsèques d'une part et les deuxièmes informations *a posteriori* d'autre part et pour fournir lesdites deuxièmes informations extrinsèques en tant qu'informations *a priori* en entrée du premier décodeur SISO de la paire suivante.

**7.** Système de transmission comportant un émetteur selon l'une des revendication 1 à 3 et un récepteur selon l'une des revendication 4 à 6.

**8.** Procédé de codage de canal et de modulation pour transformer un flux de données binaires en signaux d'ondes représentés par des symboles à transmettre destinés à transporter lesdites données binaires dans un canal de transmission, lesdits signaux d'ondes étant sélectionnés dans une constellation à M états, **caractérisé en ce que** ledit procédé comporte les étapes suivantes :

- une étape de conversion en amont pour convertir ledit flux de données binaires en un flux de symboles d'information, dit flux d'entrée, de sorte que le nombre de symboles d'entrée possibles est égal au nombre M de signaux de ladite constellation,

- une étape d'entrelacement pour entrelacer ledit flux d'entrée et pour en déduire un flux d'entrée entrelacé,

- une étape de codage à l'aide d'au moins un premier et un deuxième codeurs fonctionnant en parallèle, pour recevoir ledit flux d'entrée et ledit flux d'entrée entrelacé, respectivement, et pour délivrer des flux de sortie contenant des indications relatives auxdits symboles d'information et des premières informations de redondance introduites par le premier codeur d'une part et des deuxièmes informations de redondance introduites par le deuxième codeur d'autre part,

- une étape de sélection pour déterminer les symboles à transmettre à partir desdits flux de sortie.

**9.** Procédé de démodulation et de décodage de canal itératif pour retrouver des symboles d'information émis sélectionnés dans un alphabet à M états à partir de signaux reçus, **caractérisé en ce qu'**il comprend les étapes suivantes :

- une étape de réception pour recevoir lesdits signaux et les convertir en symboles de données, dits symboles reçus,

- une étape de calcul de vraisemblance pour délivrer des vecteurs de vraisemblance comprenant, pour chaque symbole reçu, des indications de vraisemblance relatives auxdits symboles d'information et des indications de vraisemblance relatives à des indications de redondance fournies par un codeur à l'émission à partir desdits symboles d'informations,

- une étape de décodage itératif, chaque itération comportant les sous-étapes suivantes :

   i. une première sous-étape de décodage pour délivrer :

      (a) des résultats relatifs aux symboles d'information, dites premières informations extrinsèques, et

      (b) des indications de vraisemblance *a posteriori* sur les symboles d'information, dites premières informations *a posteriori*,

   à partir :

      (c) desdits vecteurs de vraisemblance et

      (d) d'indication indépendantes des symboles reçus, relatives auxdits symboles d'information, dites informations *a priori,*

   ii. une étape d'entrelacement pour entrelacer lesdites premières informations extrinsèques et lesdits vecteurs de vraisemblance comportant les indications de vraisemblance sur les symboles reçus correspondant aux symboles d'information, pour délivrer des premières information extrinsèques entrelacées d'une part et des indications de vraisemblance entrelacées d'autre part,

iii. une deuxième sous-étape de décodage pour délivrer des deuxièmes informations extrinsèques d'une part et des indications de vraisemblance *a posteriori* sur les symboles reçus, dites deuxièmes informations *a posteriori,* d'autre part, à partir desdites premières informations extrinsèques entrelacées, utilisées en tant qu'informations *a priori*, et desdites indications de vraisemblance entrelacées,

iv. une étape d'entrelacement inverse pour desentrelacer les deuxièmes informations extrinsèques d'une part et les deuxièmes informations *a posteriori* d'autre part et pour fournir lesdites deuxièmes informations extrinsèques en tant qu'informations *a priori* en entrée de la première sous-étape de décodage de l'itération suivante,

- une étape de décision pour sélectionner des symboles d'information, à partir desdites informations *a posteriori*.

10. Programme d'ordinateur comportant des instructions de code de programme pour mettre en oeuvre un procédé selon l'une des revendication 8 ou 9.

11. Signal pour transporter un programme d'ordinateur selon la revendication 10.

EP 1 282 254 A1

FIG. 1

FIG. 2

15

FIG.3

Initialize $\alpha_0^0, \dots \alpha_{N_S-1}^0$

$L_0^t, \dots L_{k-1}^t$

Observations

$\gamma^t(S_0, \dots, S_{n-1}),$
$S_i \in M\text{-}AM$

Forward algorithm

$\alpha_0^t, \dots \alpha_{N_S-1}^t$

$A_0^t, \dots A_{k-1}^t$

Extrinsic information

$L_0^t, \dots L_{k-1}^t$

$L_k^t, \dots L_{n-1}^t$

$k$

$n\text{-}k$

Branch metric computation

APP computation

$k$

$k$

$k$

Extrinsic computation

$k$

$E_0^t, \dots E_{k-1}^t$

$A_0^t, \dots A_{k-1}^t$

$k$

APRIORI informati

$\beta_0^t, \dots \beta_{N_S-1}^t$

Backward algorithm

A Posteriori

$APP_0^t, \dots APP_{k-1}^t$

Initialize $\beta_0^N, \dots \beta_{N_S-1}^N$

## FIG. 4

**Office européen des brevets**

# RAPPORT DE RECHERCHE EUROPEENNE

Numéro de la demande

EP 02 07 7986

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | DE 199 34 646 A (UNIV DRESDEN TECH) 1 février 2001 (2001-02-01) * colonne 3, ligne 12 - colonne 4, ligne 10; figures 2,3 * | 1-4,7-11 | H04L1/00 H03M13/29 |
| X | BENEDETTO S ET AL: "SOFT-INPUT SOFT-OUTPUT MODULES FOR THE CONSTRUCTION AND DISTRIBUTED ITERATIVE DECODING OF CODE NETWORKS" EUROPEAN TRANSACTIONS ON TELECOMMUNICATIONS, EUREL PUBLICATION, MILANO, IT, vol. 9, no. 2, 1 mars 1998 (1998-03-01), pages 155-172, XP000751912 ISSN: 1124-318X * page 156, colonne de gauche, alinéa 5 * * page 158, colonne de gauche, alinéa 2 - page 159, colonne de droite, alinéa 1 * * page 161, colonne de droite, alinéa 2 - page 162, colonne de droite, alinéa 2 * * page 167, colonne de gauche, alinéa 3 - page 168, alinéa 3; figures 7,8 * | 1-4,7-11 | |
| A | BENEDETTO S ET AL: "A SOFT-INPUT SOFT-OUTPUT APP MODULE FOR ITERATIVE DECODING OF CONCATENATED CODES" IEEE COMMUNICATIONS LETTERS, IEEE SERVICE CENTER, PISCATAWAY,US, US, vol. 1, no. 1, 1997, pages 22-24, XP000643017 ISSN: 1089-7798 * le document en entier * | 4,9-11 | DOMAINES TECHNIQUES RECHERCHES (Int.Cl.7) H04L H03M |

-/--

Le présent rapport a été établi pour toutes les revendications

| Lieu de la recherche | Date d'achèvement de la recherche | Examinateur |
|---|---|---|
| LA HAYE | 24 octobre 2002 | Koukourlis, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**Office européen des brevets**

## RAPPORT DE RECHERCHE EUROPEENNE

Numéro de la demande

EP 02 07 7986

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | BAUCH G ET AL: "ITERATIVE EQUALIZATION AND DECODING IN MOBILE COMMUNICATIONS SYSTEMS" PROCEEDINGS OF EUROPEAN PERSONAL AND MOBILE COMMUNICATIONS CONFERENCE, XX, XX, 30 septembre 1997 (1997-09-30), pages 307-312, XP002060630 * figure 2 * | 1-11 | |
| A | TEN BRINK S ET AL: "Iterative demapping for QPSK modulation" ELECTRONICS LETTERS, IEE STEVENAGE, GB, vol. 34, no. 15, 23 juillet 1998 (1998-07-23), pages 1459-1460, XP006010100 ISSN: 0013-5194 * le document en entier * | 1-11 | |

**DOMAINES TECHNIQUES RECHERCHES (Int.Cl.7)**

Le présent rapport a été établi pour toutes les revendications

| Lieu de la recherche | Date d'achèvement de la recherche | Examinateur |
|---|---|---|
| LA HAYE | 24 octobre 2002 | Koukourlis, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 02 07 7986

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-10-2002

| Document brevet cité au rapport de recherche | Date de publication | Membre(s) de la famille de brevet(s) | Date de publication |
|---|---|---|---|
| DE 19934646 A | 01-02-2001 | DE 19934646 A1 | 01-02-2001 |
| | | AU 6979300 A | 05-02-2001 |
| | | WO 0106662 A1 | 25-01-2001 |
| | | DE 10082067 D2 | 26-09-2002 |

EPO FORM P0460

Pour tout renseignement concernant cette annexe : voir Journal Officiel de l'Office européen des brevets, No.12/82